Europäisches Patentamt

European Patent Office

Office européen des brevets

Veröffentlichungsnummer: **0 286 855**
**A1**

# EUROPÄISCHE PATENTANMELDUNG

Anmeldenummer: **88104154.5**

Anmeldetag: **16.03.88**

Int. Cl.4 **H01L 21/308 , H01L 29/06**

Priorität: **15.04.87 CH 1475/87**

Veröffentlichungstag der Anmeldung:
**19.10.88 Patentblatt 88/42**

Benannte Vertragsstaaten:
**CH DE FR GB LI**

Anmelder: **BBC Brown Boveri AG**
**Haselstrasse**
**CH-5401 Baden(CH)**

Erfinder: **Voboril, Jan**
**Landschreiberstrasse 2**
**CH-5415 Nussbaumen(CH)**

Verfahren zum Aetzen von Vertiefungen in ein Siliziumsubstrat.

Bei einem Verfahren zum Aetzen kompliziert strukturierter Vertiefungen in ein Siliziumsubstrat (1), bei welchem HF und $HNO_3$ enthaltende Säuremischungen verwendet werden, werden die mit einer Maske aus Photolack auftretenden Probleme umgangen, indem einerseits eine Maskenschicht (2) aus $SiO_2$ verwendet wird, und andererseits die Maskenschicht (2) mit einem dem zu ätzenden Tiefenprofil entsprechenden Dickenprofil vorfabriziert wird.

Auf diese Weise können Maskierungs-und Aetzschritte vollstandig voneinander getrennt werden.

FIG.3A

FIG.1

## Verfahren zum Aetzen von Vertiefungen in ein Siliziumsubstrat

### Technisches Gebiet

Die vorliegende Erfindung bezieht sich auf das Gebiet der Halbleitertechnologie. Sie betrifft insbesondere ein Verfahren zum Aetzen von Vertiefungen in ein Siliziumsubstrat, wobei Vertiefungen mit variierendem Tiefenprofil erzeugt werden, und bei welchem Verfahren
- das Siliziumsubstrat mit einer ätzresistenten Maskenschicht abgedeckt wird;
- die Maskenschicht strukturiert wird; und
- die Vertiefungen nasschemisch mit einer HF und $HNO_3$ enthaltenden Aetzmischung geätzt werden.

### Stand der Technik

Zum Erzeugen verschiedener topologischer Strukturen in einem Siliziumsubstrat, beispielsweise Passivierungsgräben bei einem Leistungsthyristor, werden häufig isotrop wirkende Säuremischungen verwendet.

Die geläufigsten Säuremischungen bestehen aus Flusssäure (HF). Salpetersäure ($HNO_3$) und sind mit Essigsäure ($CH_3COOH$ bzw. $HC_2H_3O_2$), Wasser oder anderen Zutaten verdünnt. Wie aus dem Artikel von B. Schwartz und H. Robbins, "Chemical Etching of Silicon, J. Electrochem. Soc., Vol. 123, No. 12 (Dez. 1976), S. 1903-1909 (siehe dort Fig. 8 und 9) bekannt ist, bestimmt die Zusammensetzung der Säuremischung die Aetzrate, aber auch die topologische Struktur der geätzten Oberfläche, bzw. den Verlauf der entstehenden Konturen, wenn maskiert geätzt wird.

Wie aus Fig. 8 der zitierten Druckschrift zu entnehmen ist, erreicht die Aetzrate eine Maximum, wenn HF und $HNO_3$ im Verhältnis von etwa 7:3 gemischt werden und sich damit im stöchiometrischen Gleichgewicht befinden.

Von einem solchen Mischungsverhältnis ausgehend kann die Aetzrate dann durch Zugabe von $CH_3COOH$ gesteuert werden. Enthält die Säuremischung mehr als 40 % Essigsäure, sinkt die Aetzrarte schliesslich praktisch auf Null.

Wie bereits erwähnt, ist die Struktur der geätzen Oberfläche ebenfalls durch die Zusammensetzung der Säuremischung gegeben. Der entprechenden Fig. 9 der zitierten Druckschrift ist in diesem Zusammenhang zu entnehmen, dass die o.g. stöchiometrische Zusammensetzung keine wünschenswerte Oberflächenbeschaffenheit liefert. Darüberhinaus ist die mit dieser Zusammensetzung vorgegebene hohe Aetzrate nicht gerade erwünscht, da der Aetzprozess schlechter kontrollierbar ist.

Will man kontrolliert ätzen und glatte und glänzende Oberflächen erreichen, muss das Verhältnis $HF:HNO_3$ zugunsten der Salpetersäure verändert werden. Dadurch wird nämlich die Lösung des entstehenden $SiO_2$ durch die Flusssäure zum Aetzraten-limitierenden Faktor, und Kristalldefekte. Dotierung und Orientierung haben auf die Aetzrate fast keinen Einfluss. Die $HNO_3$-reichen Aetzmischungen wirken insbesondere polierend.

Will man nun Strukturen in ein Siliziumsubstrat ätzen, müssen die Teile der Oberfläche, die nicht geätzt werden sollen, abgedeckt (maskiert) werden.

Es ist dabei bekannt (siehe z.B. die DE-OS 33 34 095), für eine solche Maskierung Photolacke zu verwenden, die, mit oder ohne zusätzliche Haftschicht, auf das Siliziumsubstrat aufgebracht und anschliessend photolithographisch strukturiert werden. Mit der Verwendung von Photolack muss aber ein weiterer, die Wahl der Säuremischung einschränkender Faktor berücksichtigt werden, da der Photolack im Allgemeinen durch $HNO_3$ angegriffen wird.

Zum Aetzen der bis zu 10 μm feinen oder sogar noch feineren Strukturen wird üblicherweise ein negativ arbeitender Photolack als Aetzmaske verwendet, weil positiv arbeitende Photolacke wegen ihrer wesentlich geringeren Beständigkeit gegen die gebräuchlichen Säuremischungen als Aetzmaske unbrauchbar sind.

Insgesamt hat die Verwendung von Photolacken eine Reihe von Nachteilen:

1) Die Wahl der Säuremischung ist stark begrenzt. Das Verhältnis $HF:HNO_3$ soll grösser als 1:3 sein. Säuremischungen, die 100%ige $HNO_3$ enthalten und spiegelnde Oberflächen liefern, greifen den Photolack innerhalb weniger Sekunden an und der Aetzvorgang ist dann auf diese Weise nicht maskierbar.

2) Die Beständigkeit des Photolacks auch gegen weniger aggressive Säuremischungen ist von mehreren Faktoren abhängig (wie z.B. Lackdicke, Vortrocknen, Belichtung, Lackalter), und die Aetzbadtemperatur muss gesenkt werden, um jene zu verlängern.

3) Die Lackhaftung (insbesondere ohne zusätzliche Haftschicht) ist wie die Lackbeständigkeit von photolithographischen Prozess aber auch von der Oberflächenbeschaffenheit des Siliziumsubstrats abhängig. In der Regel ist die Lackhaftung auf einer rauhen Si-Oberfläche grösser. Das Maskieren einer po lierten Oberfläche, die gerade aus anderen Gründen wünschenswert ist, bereitet erhebliche Probleme (siehe dazu die DE-OS 33 34 095). Vor allem wird die Lackkante stark beansprucht, da durch das Unterätzen die Säure Zugriff zu den unteren weichen Lackschichten gewinnt und so ein beschleunigtes Unterätzen zur Folge hat.

4) Das Ablaufen der Lacklebensdauer beginnt beim ersten Eintauchen in die Säuremischung. Die Lacklebensdauer in der Säuremischung beträgt nur wenige Minuten und wird durch eine Unterbrechung des Aetzprozesses eher undefiniert verkürzt, sodass eine kontrollierte Fortsetzung des Aetzprozesses nach einer Unterbrechung nicht möglich ist.

5) Beim Photolack-Prozess bleiben nach der Entfernung der unbelichteten Lackflächen durch den Entwickler hauchdünne Lackreste zurück. Diese Lackreste verursachen einen ungleichmässigen Aetzabtrag in der ersten Aetzphase, was zu einer rauhen Oberfläche führt. Auch verschwindet diese Rauhigkeit nicht restlos, weil die in Frage kommenden Aetzmischungen schwächere Poliereigenschaften besitzen.

6) Während des Aetzens quillt der Photolack auf und die Säuremischung kann durch die organischen Substanzen entwertet werden.

7) Nach dem Aetzprozess muss der Lack entfernt werden, was wieder mit organischen Substanzen durchgeführt wird. Die frisch geätzte Silizium-Oberfläche wird damit kontaminiert, was einen sehr negativen Einfluss auf die elektrischen Eigenschaften der hergestellten Halbleiterstrukturen hat und eine komplizierte Nachbehandlung erforderlich macht.

Neben diesen allgemein mit einer Photolackmaske verbundenen Nachteilen treten weitere Probleme auf, wenn in das Siliziumsubstrat Vertiefungen eingeätzt werden sollen, die ein variierendes Tiefenprofil aufweisen.

Bie solchen Vertiefungen mit variierendem Tiefenprofil kann es sich beispielsweise um Gräben mit einer Anschrägung handeln, wie sie aus der DE-PS 23 59 511 bekannt sind, oder um stufenförmige Doppelgräben (sog. "Doppel-Moats"), wie sie als Passivierungsgräben aus der EP-A2 0 178 387 (Fig. 2) bekannt sind.

Das aus der DE-PS 23 59 511 bekannte Verfahren zur Erzeugung des angeschrägten Grabens ist auf eine ganz spezielle Aetzmischung und Orientierung des Siliziumsubstrats angewiesen und eignet sich insbesondere nicht zur Herstellung von Vertiefungen mit andersartigen Tiefenprofilen (z.B. den Doppelgraben).

Andererseits müsste beispielsweise beim Aetzen eines Doppelgrabenz zwischen zwei Aetzschritte (für jeden der Gräben) noch einmal ein Maskierungsschritt eingeschaltet werden, wobei die bereits strukturierte Oberfläche beim Aufbringen (Aufschleudern) und Entwickeln des Photolacks Probleme bereitet.

## Darstellung der Erfindung

Aufgabe der vorliegenden Erfindung ist es nun, ein Verfahren zum Aetzen von Vertiefungen mit variierendem Tiefenprofil in ein Siliziumsubstrat anzugeben, welches einerseits die mit einer Photolack-Maske verbundenen Nachteile vermeidet und andererseits zur Erzeugung beliebiger Tiefenprofile verwendet werden kann.

Die Aufgabe wird bei einem Verfahren der eingangs genannten Art dadurch gelöst, dass
- eine Maskenschicht aus $SiO_2$ verwendet wird;
- bei der Strukturierung der Maskenschicht Bereiche mit variierendem Dickenprofil der Maskenschicht erzeugt werden; und
- die Bereiche mit variierendem Dickenprofil zur Erzeugung des variierenden Tiefenprofils der Vertiefungen verwendet werden.

Der Kern der Erfindung ist darin zu sehen, dass als Maske eine $SiO_2$-Maskenschicht verwendet wird, die bereits von vornherein durch die Strukturierung ein variierendes Dickenprofil erhält, das dem später zu ätzenden variierenden Tiefenprofil entspricht, sodass mit einer einzigen Maskenschicht die unterschiedlichen Aetztiefen realisiert werden können.

Die erfindungsgemässe Maskentechnik hat die folgenden Vorteile:

1) Die Wahl der Säuremischung ist in der Richtung zum $HNO_3$ unbegrenzt, da die $SiO_2$-Maskenschicht nur durch HF angegriffen wird. Es können daher auch $HNO_3$-reiche (auch 100%ige $HNO_3$ enthaltende), polierende und sonst unmaskierbare Sauremischungen verwendet werden. Zum Strukturieren der $SiO_2$-Schicht können auch positiv arbeitende Photolacke verwendet werden. Das Aetzen der $SiO_2$-Schicht selbst ist im übrigen weitgehend etablierte und problemlos beherrschte Technik.

2) Die Beständigkeit der $SiO_2$-Schicht ist nur durch die Säuremischung gegeben. Das Aetzratenverhältnis $Si:SiO_2$ ist sogar temperaturunabhängig, sodass das Aetzen in einem grossen Temperaturintervall erfolgen kann.

3) Die Haftung der Maskenschicht bereitet keine Probleme, insbesondere wenn gemäss einer bevorzugten Ausführungsform der Erfindung das $SiO_2$ thermisch aufgewachsen ist. Gerade thermisch gewachsenes $SiO_2$ bildet mit dem Siliziumsubstrat ein kompaktes Material. Eine polierte Oberfläche ist hier von Vorteil, weil dann die $SiO_2$-Schicht besonders gleichmässig ist.

Die Maskenkante ist durch den Aetzprozess selbst perfekt geschützt: Die Aetzmischung, die mit einem Ueberschuss an $HNO_3$ arbeitet, wird durch den Aetzprozess lokal über dem unmaskierten Si um den HF-Anteil verarmt. Dadurch ist der Abtrag der

$SiO_2$-Maskenschicht an dieser exponierten Stelle reduziert. Diese reduzierte Aetzrate am Maskenrand wurde bei Versuchen tatsächlich beobachtet und liegt je nach Aetzmischung und Struktur um 9-14 % unter der Aetzrate auf einer durchgehenden $SiO_2$-Schicht.

4) Die Lebensdauer der $SiO_2$-Maskenschicht wird nicht durch eine Unterbrechung im Aetzvorgang unkontrollierbar beeinflusst. Der Aetzprozess kann mehrmals zu Kontrollzwecken unterbrochen werden, ohne dass die Maske darunter leidet. Dies hat weiterhin den Vorteil, dass man nach der Unterbrechung in ein anderes Aetzbad gehen und dabei die Wahl der anderen Aetzlösung anderen Kriterien (z.B. Leckstromreduktion) unterordnen kann.

5) Die $SiO_2$-Maskenschicht erlaubt alle üblichen Reinigungsprozeduren für das Siliziumsubstrat, die zum Entfernen von organischen und metallischen Verunreinigungen notwendig sind. Beim Aetzprozess selbst sind keine organischen Substanzen mehr anwesend, sodass sie Säuremischung nicht entwertet werden kann.

6) Im Prinzip muss die $SiO_2$-Maske nach dem Aetzprozess nicht gleich entfernt werden: Da die Struktur mit der $SiO_2$-Schicht sehr beständig ist, können andere Prozesse (z.B. die Passivierung) folgen, und das Entfernen der $SiO_2$-Maske oder deren Teile an Stellen, wo z.B. kontaktiert werden soll, zu einem späteren Zeitpunkt in der Prozessfolge verschoben werden.

7) Gerade beim Aetzen komplizierter Strukturen mit variierendem Tiefenprofil kann die gewünschte Struktur in der $SiO_2$-Maskenschicht stärkenmässig verkleinert vorfabriziert werden, sodass nur noch Aetzschritte folgen, ohne dass zwischendurch wieder neu maskiert werden muss. Maskieren und Aetzen sind damit getrennte Prozessteile. Das Maskieren selbst erfolgt auf der planen Oberfläche und wird daher nicht durch bereits vorhandene Strukturen beeinträchtigt.

Gemäss einem bevorzugten Ausführungsbeispiel der Erfindung besteht die Maskenschicht aus thermisch aufgewachsenem $SiO_2$ und es wird als Aetzmischung eine $HNO_3$-reiche, polierende Säuremischung verwendet.

Weitere Ausführungsbeispiele ergeben sich aus den Unteransprüchen.

Kurze Beschreibung der Zeichnung

Die Erfindung soll nachfolgend anhand von Ausführungsbeispielen im Zusammenhang mit der Zeichnung näher erläutert werden. Es zeigen:

Fig.1 die bekannte Darstellung der Aetzraten im Mischungssystem HF - $HNO_3$ -$CH_3COOH$;

Fig.2A-E verschiedene Schritte bei der Aetzung eines Doppelgrabens (Doppel-Moat) mit herkömmlicher Photolackmaskierung;

Fig.3A-I verschiedene Schritte bei der Aetzung eines Doppelgrabens gemäss einem ersten Ausführungsbeispiel der Erfindung,

Fig.4A-D verschiedene Schritte bei der Aetzung einer Vertiefung mit Anschrägung gemäss einem zweiten Ausführungsbeispiel der Erfindung;

Fig.5 das gemessene Tiefenprofil eines gemäss Fig. 3A-I hergestellten Doppelgrabens; und

Fig.6 das gemessene Tiefenprofil einer gemäss Fig. 4A-D hergestellten Anschrägung.

Wege zur Ausführung der Erfindung

Beim erfindungsgemässen Verfahren spielt die als Aetzmischung verwendete Säuremischung mit HF, $HNO_3$ und auch $CH_3COOH$ (bzw. $HC_2H_3O_2$) eine wichtige Rolle.

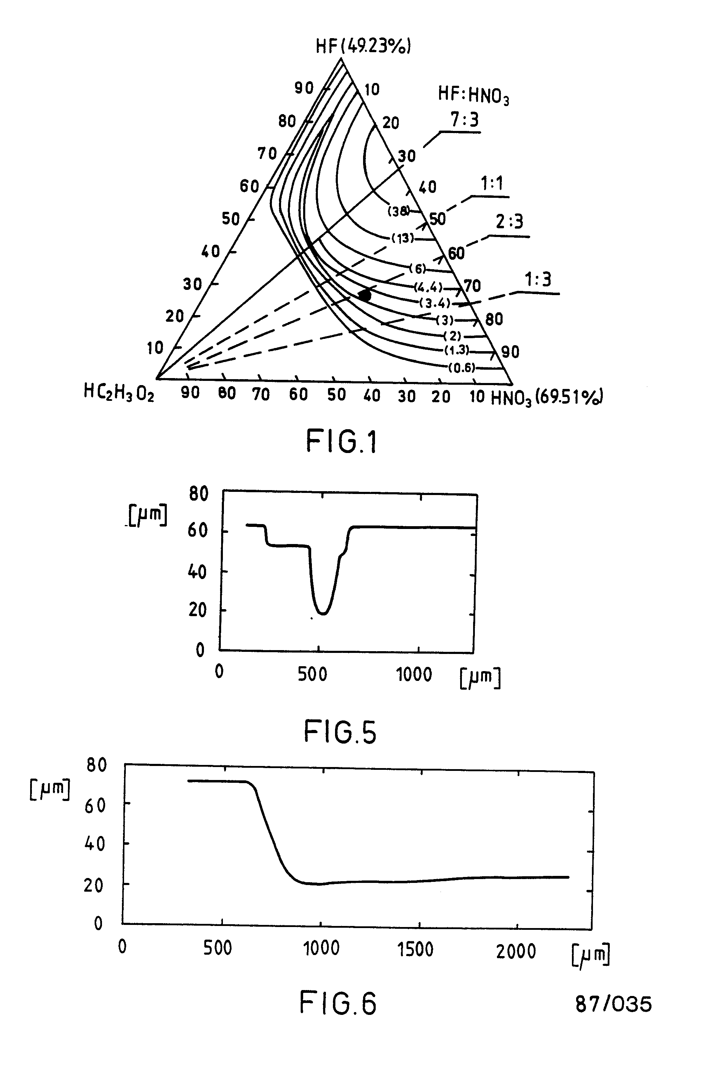

In Fig. 1 ist daher im wesentlichen die Fig. 8 aus dem eingangs zitierten Artikel von Schwartz und Robbins wiedergegeben, in welcher die Kurven konstanter Aetzrate (angegeben in mil/Minute) für das 3-komponentige Mischungssystem HF-$HNO_3$-$CH_3COOH$ eingetragen sind. Bei einer Interpretation dieser Darstellung ist zu berücksichtigen, dass für die Säuren HF und $HNO_3$ von den in Klammern angegebenen Konzentrationen ausgegangen worden ist.

Zusätzlich zu den Kurven konstanter Aetzrate sind in Fig. 1 Linien konstanten Mischungsverhältnisses von HF:$HNO_3$ für ausgewählte Verhältnisse (7:3; 1:1; 2:3 und 1:3) eingetragen.

Wie eingangs schon dargelegt wurde, ergeben sich für die stöchiometrische Mischung entlang der zum Verhältnis 7:3 gehörenden Linie die höchsten Aetzraten. Beim Verhältnis von 2:3 liegt eine als voller Punkt eingezeichnete Aetzmischung mit der Kurzbezeichnung CP-8, die im Zusammenhang mit dem erfindungsgemässen Verfahren ausprobiert worden ist und später noch beschrieben wird. Die zum Verhältnis 1:3 gehörende Linie stellt schliesslich die untere Grenze für die Anwendung einer Photolack-Maske dar.

Für die saubere Aetzung von Vertiefungen mit guter Oberflächenbeschaffenheit sind nun vor allem $HNO_3$-reiche, polierende Aetzmischungen geeignet, die mit ihrem (HF:$HNO_3$)-Verhältnis deutlich unterhalb der eingezeichneten (1:1)-Linie liegen.

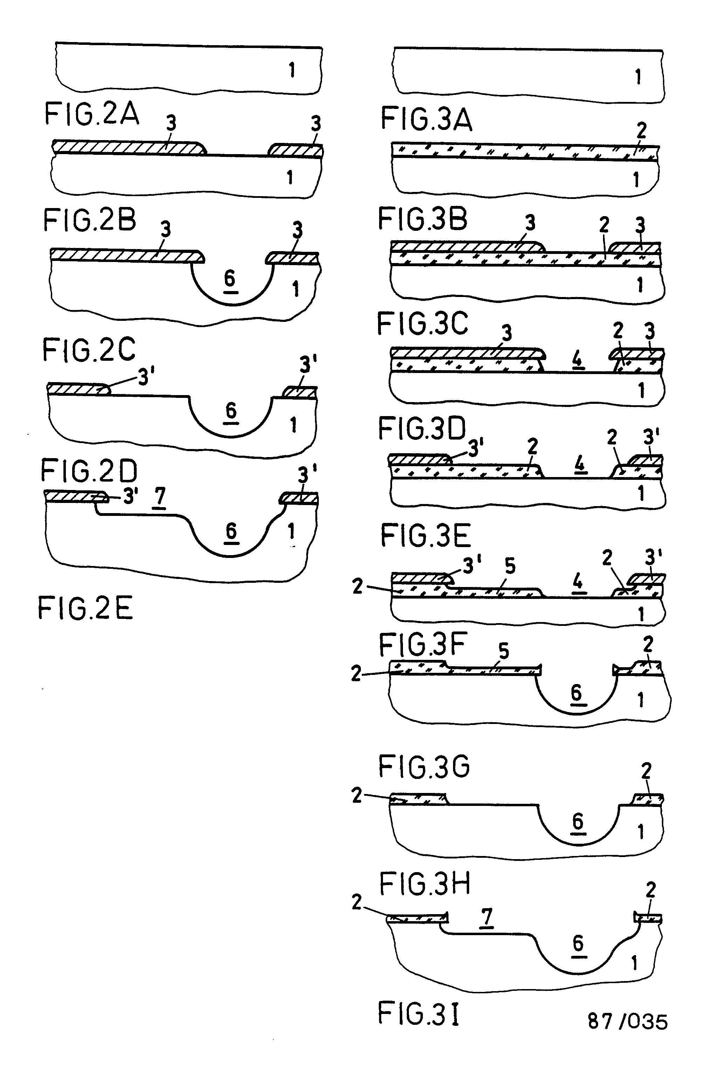

Die Unterschiede zwischen einem mit $SiO_2$-Maskenschicht und einem mit Photolack-Maske arbeitenden Verfahren können an dem ersten Ausführungsbeispiel, dem Aetzen eines Doppelgrabens, durch Vergleich der Fig. 2A-E und 3A-I deutlich gemacht werden:

Ein herkömmliches, mit Photolackmaske arbeitendes Verfahren (Fig. 2A-E) geht aus von einem Siliziumsubstrat 1 (Fig. 2A-E) mit ebener Oberfläche. In dieses Siliziumsubstrat 1 können bereits die für ein Halbleiterbauelement notwendigen Schichtstrukturen eingebracht worden sein.

Auf das Siliziumsubstrat 1 wird nun eine dünne Photolackschicht aufgebracht (z.B. aufgeschleudert), wärmetechnisch behandelt und photolithographisch zu einer ersten Lackmaske 3 strukturiert (Fig. 2B), die in den Bereichen, in denen der Doppelgraben entstehen soll, entsprechende Oeffnungn aufweist.

Durch diese Oeffnungen hindurch wird in einem ersten Aetzschritt mit einer relativ $HNO_3$-armen Aetzmischung ein tiefer erster Graben 6 in das Siliziumsubstrat 1 geätzt, der wegen der isotroper Aetzeigenschaften gerundet erscheint (Fig. 2C).

Nach Abschluss der ersten Grabenätzung wird die Lackmaske 3 entfernt und eine zweite Photolackschicht aufgebracht und zu einer zweiten Lackmaske 3′ strukturiert (Fig. 2D). Die Oeffnungen in dieser zweiten Lackmaske 3′ legen dann die Bereiche eines flachen zweiten Grabens 7 fest, der in einem zweiten Aetzschritt in das Siliziumsubstrat 1 eingeätzt wird (Fig. 2E). Die Ueberlagerung von erstem Graben 6 und zweitem Graben 7 bildet den Doppelgraben (Doppel-Moat), wie er als Passivierungsgraben bei Leistungshalbleiterbauelementen Verwendung findet.

Es ist unmittelbar einleuchtend, dass, neben den sonstigen mit einer Photolack-Maske verbundenen Nachteilen, bei dem gerade beschriebenen Verfahren vor allem durch die Verzahnung von Aetz-und Maskierungsschritten wegen der damit verbundenen Wechselwirkung und Kontaminierung frisch geätzter Flächen besondere Probleme auftreten.

Bei dem Ausführungsbeispiel des erfindungsgemässen Verfahrens, wie es in den Fig. 3A-I dargestellt ist, werden diese Probleme sicher vermieden:

Auch hier wird von dem Siliziumsubstrat 1 ausgegangen (Fig. 3A), auf dem durch thermisches Aufwachsen eine gleichmässige Maskenschicht 2 aus $SiO_2$ erzeugt wird, die mit dem Siliziumsubstrat 1 äusserst eng verbunden ist (Fig. 3B).

Auf die Maskenschicht 2 wird nun, analog zu Fig. 2B, eine erste Photolackschicht aufgebracht und zu einer erstent Lackmaske 3 strukturiert (Fig. 3C). Durch die Oeffnung der ersten Lackmaske 3 hindurch wird mit einer für $SiO_2$ geeigneten Aetze die Maskenschicht 2 in einer Maskenöffnung 4 vollständig entfernt (Fig. 3D).

Nach Auflösen der ersten Lackmaske 3 wird, analog zu Fig. 2D, eine zweite Photolackschicht aufgetragen und zu einer zweiten Lackmaske 3′ strukturiert (Fig. 3E).

Im Oeffnungsbereich der zweiten Lackmaske 3′ wird dann die Maskenschicht 2 soweit abgetragen, dass eine Maskenstufe 5 entsteht, die Maskenschicht 2 also ein stufenförmiges Dickenprofil aufweist (Fig. 3F). Mit Einbringen der Maskenstufe 5 in die Maskenschicht 2 und Entfernen der zweiten Lackmaske 3′ ist der Maskierungsprozess vollkommen abgeschlossen, und es folgen nurmehr "saubere" Aetzschritte (Fig. 3G-I).

Zunächst wird dabei mit der HF und $HNO_3$ enthaltenden Aetzmischung durch die Maskenöffnung 4 hindurch der tiefe erste Graben 6 ausgehoben (Fig. 3G).

Es folgt eine ganzflächige, unmaskierte Abtragung der Maskenschicht 2, bis die Maskenstufe 5 vollumfänglich entfernt ist und das Siliziumsubstrat 1 auch in diesem Bereich freiliegt (Fig. 3H).

Schliesslich wird durch die vergrösserte Oeffnung in der Maskenschicht 2 der flache zweite Graben 7 in das Siliziumsubstrat 1 hineingeätzt (Fig. 3I). Sowohl in Fig. 3G als auch in Fig. 3I ist an den Ränder der Maskenschicht 2 die wegen der verringerten Aetzrate entstehende Randüberhöhung angedeutet.

An dem in Fig. 3A-I dargestellten Ausführungsbeispiel lässt sich erkennen, dass zum Aetzen einer Vertiefung mit stufenförmigem Tiefenprofil eine ähnliche Struktur mit stufenförmigem Dickenprofil in der Maskenschicht vorfabriziert werden kann, sodass nach Abschluss der Maskenherstellung nur noch Aetzschritte durchgeführt werden müssen, die weder frisch geätzte Oberflächen kontaminieren, noch durch organische Substanzen beeintrachtigt werden.

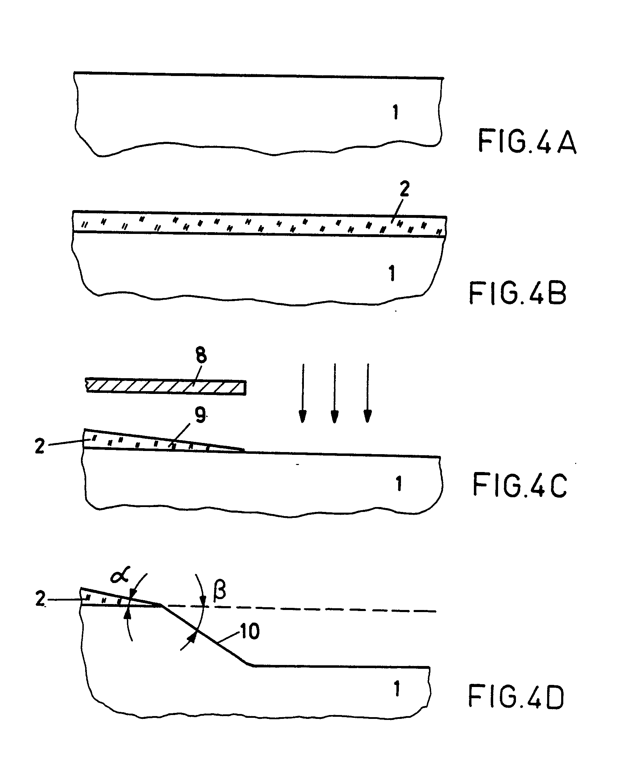

Aehnlich wie eine Vertiefung mit stufenförmigem Tiefenprofil durch eine vorfabrizierte Maskenschicht mit stufenförmigen Dikkenprofil erzeugt werden kann, kann auch eine Vertiefung mit einer Anschrägung am Rand durch eine vorfabrizierte Maskenschicht mit einem Maskenkeil am Maskenrand verwirklicht werden (Fig. 4A-D).

Auch hierbei wird von dem Siliziumsubstrat 1 ausgegangen (Fig. 4A), auf dem durch thermisches Aufwachsen die $SiO_2$-Maskenschicht 2 erzeugt wird (Fig. 4B).

Werden in diese Maskenschicht 2 die für das Aetzen der Vertiefung notwendigen Oeffnungen mittels des bekannten reaktiven Ionenätzens durch eine in endlichem Abstand über der Maskenschicht angeordnete Blende (Fig. 4C) eingeätzt, entsteht durch den Schattenwurf im Bereich des Blendenrands ein Maskenkeil 9, d.h. der am Rande der Oeffnung liegende Bereich der Maskenschicht 2 ist keilförmig angeschrägt.

Beim nachfolgenden Aetzen der Vertiefung mit der Säuremischung wird der Maskenkeil von der Oeffnungsseite her nach und nach abgetragen und der darunterliegende Bereich des Siliziumsubstrats 1 nach und nach dem Aetzangriff ausgesetzt, sodass am Rande der Vertiefung eine Anschrägung 10 entsteht (Fig. 4D), deren Anschrägwinkel $\beta$ zum Keilwinkel $\alpha$ des Maskenkeils 9 im folgenden Verhältnis steht:

$$tg\beta \quad tg\alpha \approx R_{Si} \quad R_{SiO2}$$

wobei $R_{Si}$ und $R_{SiO2}$ die Aetzraten der Säuremischung für Si bzw. SiO$_2$ sind.

In entsprechenden Versuchen mit mehreren Aetzmischungen wurden sowohl das stufenförmige als auch das schräg abfallende Tiefenprofil realisiert. Es wurden insgesamt drei Aetzmischungen getestet:

No. 1 (CP-8): 270 ml HF (50 %) + 270 ml CH$_3$COOH (99,5 %) + 450 ml HNO$_3$ (65 %)

No. 2 (Monsanto): 156 ml HF (50 %) + 218 ml CH$_3$COOH (99,5 %) + 500 ml HNO$_3$ (100 %)

(dies entspricht in vol-% ungerechnet 18 vol-% HF + 25 vol-% CH$_3$COOH + 57 vol-% HNO$_3$)

No. 3 (Grabenbeize): 230 ml HF (50 %) + 470 ML HNO$_3$ (65 %) + 200 ml CH$_3$COOH (100 %) + 100 ml H$_3$PO$_4$

Die in Klammern angegebenen Prozentzahlen stellen die jeweilige Ausgangskonzentration dar.

Als beste Aetsmischung hat sich die No. 2 (Monsanto) erwiesen mit einem Aetzratenverhältnis $R_{Si}$ $R_{SiO2}$ von 100:1. Bei der Mischung No. 3 liegt dieses Verhältnis immerhin noch bei brauchbaren 50:1. Die Mischung No. 1 (CP-8) hat von allen drei Aetzmischungen in Hinsicht auf defektfreies Aetzen das ungünstigste (HF:HNO$_3$)-Verhältnis und erscheint deshalb nicht so gut geeignet.

Ein Doppelgraben (stufenförmiges Tiefenprofil) wurde mit der Aetzmischung No. 2 bei einer Aetztemperatur von 25 °C in noch nie erreichter Qualität geätzt. Die Dicke der Maskenschicht 2 betrug dabei ausserhalb der Maskenstufe 5 etwa 1 $\mu$m (genau: 0.98 $\mu$m) und innerhalb der Maskenstufe 5 etwa 0,45 $\mu$m (genau: 0,44 $\mu$m). Die Aetzfolge war dabei:

a) No.2: 4 min bei 25 °C,
b) SiO$_2$-Aetze: 1,5 min bei 25 °C, und
c) No.2: 1 min bei 25 °C.

Damit wurden Aetztiefen von 44 $\mu$m in ersten Graben 6 und 10 $\mu$m im zweiten Graben 7 erreicht. Das gemessene, resultierende Tiefenprofil ist in Fig. 5 wiedergegeben, wobei auf beiden Achsen die Nullpunkte willkürlich gewählt sind.

Ein entsprechendes gemessenes Tiefenprofil für eine Vertiefung mit Anschrägung ist in Fig. 6 dargestellt. Der Maskenkeil 9 der etwa 1 $\mu$m (genau: 0,98 $\mu$m) dicken SiO$_2$-Maskenschicht 2 hatte hierbei einen Keilwinkel $\alpha$ mit tg$\alpha \approx$ 0,002: das Aetzen wurde wiederum mit der Aetzmischung No. 2 durchgeführt. Die resultierende Anschrägung 10 mit einem Anschrägungswinkel $\beta$ mit tg$\beta \approx$ 0,22 weicht nur geringfügig von der nach obiger Gleichung zu erwartenden Form ab.

Insgesamt steht mit der Erfindung ein Verfahren zum Aetzen komplizierter Strukturen zur Verfügung, das nicht nur die mit einer Lackmaske behafteten Probleme überwindet, sondern auch durch die strikte Trennung von Maskierungs-und Aetzschritten zu besonders guten Aetzergebnissen führt.

## Ansprüche

1. Verfahren zum Aetzen von Vertiefungen in ein Siliziumsubstrat (1), wobei Vertiefungen mit variierendem Tiefenprofil erzeugt werden, und bei welchem Verfahren

a) das Siliziumsubstrat (1) mit einer ätzresistenten Maskenschicht (2) abgedeckt wird;

b) die Maskenschicht (2) strukturiert wird; und

c) die Vertiefungen nasschemisch mit einer HF und HNO$_3$ enthaltenden Aetzmischung geätzt werden;

dadurch gekennzeichnet, dass

d) eine Maskenschicht aus SiO$_2$ verwendet wird:

e) bei der Strukturierung der Maskenschicht (2) Bereiche mit variierendem Dickenprofil der Maskenschicht (2) erzeugt werden; und

f) die Bereiche mit variierendem Dickenprofil zur Erzeugung des variierenden Tiefenprofils der Vertiefungen verwendet werden.

2. Verfahren nach Anspruch 1, dadurch gekennzeichnet, dass die Maskenschicht (2) aus thermisch aufgewachsenem SiO$_2$ besteht.

3. Verfahren nach Anspruch 2, dadurch gekennzeichnet, dass als Aetzmischung eine HNO$_3$-reiche, polierende Säuremischung verwendet wird.

4. Verfahren nach Anspruch 3, dadurch gekennzeichnet, dass eine Aetzmischung verwendet wird, die ein Verhältnis der Aetzraten für Si und SiO$_2$ von grösser gleich 50:1, vorzugsweise grösser gleich 100:1 aufweist.

5. Verfahren nach Anspruch 4, dadurch gekennzeichnet, dass sich die Aetzmischung wie folgt zusammensetzt:

etwa 18 vol-%  50 %ige HF;
etwa 25 vol-%  99,5 %ige CH$_3$COOH; und
etwa 57 vol-%  100 %ige HNO$_3$

6. Verfahren nach Anspruch 1, dadurch gekennzeichnet, dass

a) die Vertiefungen die Form eines aus einem tiefen ersten Graben (6) und einem flachen zweiten Graben (7) bestehenden Doppelgrabens (Doppel-Moat) mit im wesentlichen stufenförmigem Tiefenprofil haben;

b) die Bereich mit variierendem Dickenprofil als Maskenstufen (5) ausgebildet sind;

c) bei der Aetzung in einem ersten Aetzschritt durch Maskenöffnungen (4) hindurch die ersten Gräben (6) in das Siliziumsubstrat (1) hineingeätzt werden;

d) in einem zweiten Aetzschritt die Maskenschicht (2) soweit abgetragen wird, bis die Maskenstufen (5) der Maskenschicht (2) entfernt sind; und

e) in einem dritten Aetzschritt in den Bereichen der vormaligen Maskenstufen (5) die zweiten Gräben (7) in das Siliziumsubstrat (1) hineingeätzt werden.

7. Verfahren nach Anspruch 6, dadurch gekennzeichnet, dass die Maskenschicht (2) ausserhalb der Maskenstufen (5) eine Dicke von etwa 1 $\mu$m, und innerhalb der Maskenstufen (5) eine Dicke von etwa 0,45 $\mu$m aufweist.

8. Verfahren nach Anspruch 1, dadurch gekennzeichnet, dass

a) die Vertiefungen am Rand eine Anschrägung (10) aufweisen;

b) die Bereiche mit variierendem Dickenprofil als Maskenkeile (9) ausgebildet sind; und

c) die Anschrägungen (10) durch stetiges Abtragen der Maskenkeile (9) beim Aetzvorgang erzeugt werden.

9. Verfahren nach Anspruch 8, dadurch gekennzeichnet, dass die Maskenschicht (2) ausserhalb der Maskenkeile (9) eine Dicke von etwa 1 $\mu$m, und die Maskenkeile (9) einen Keilwinkel $\alpha$ mit $tg\alpha \approx 0.002$ aufweisen.

10. Verfahren nach Anspruch 8, dadurch gekennzeichnet, dass die Maskenkeile (9) durch eine Strukturierung der Maskenschicht (2) erzeugt werden, bei welcher durch eine im endlichen Abstand über der Maskenschicht (2) angeordneten Blende (8) die Maskenschicht (2) mittels des reaktiven Ionenätzens abgetragen wird.

FIG.1

FIG.5

FIG.6

FIG.2A

FIG.3A

FIG.2B

FIG.3B

FIG.2C

FIG.3C

FIG.2D

FIG.3D

FIG.2E

FIG.3E

FIG.3F

FIG.3G

FIG.3H

FIG.3I

FIG.4A

FIG.4B

FIG.4C

FIG.4D

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 164 645 (BROWN, BOVERI & CIE) <br> * Ansprüche 3-5 * <br> --- | 1-7 | H 01 L 21/308 <br> H 01 L 29/06 |
| A | EP-A-0 001 100 (IBM) <br> * Figuren 1A-1E; Seite 7, Zeile 20 - Seite 8, Zeile 29 * <br> --- | 1 | |
| A | DE-A-2 651 125 (HITACHI) <br> * Figuren 2A-2F; Seite 5, letzter Absatz - Seite 6, Zeile 17 * <br> --- | 1-7 | |
| A | EP-A-0 168 771 (SIEMENS) <br> * Zusammenfassung; Figur 2 * <br> ----- | 8-10 | |

|  |  |
|---|---|
|  | **RECHERCHIERTE SACHGEBIETE (Int. Cl.4)** <br><br> H 01 L |

Der vorliegende Recherchenbericht wurde für alle Patentansprüche erstellt

| Recherchenort | Abschlußdatum der Recherche | Prüfer |
|---|---|---|
| DEN HAAG | 02-06-1988 | GORI P. |